# EUROPEAN PATENT SPECIFICATION

(11) **EP 1 729 358 B1**
(45) Date of publication and mention of the grant of the patent: **02.03.2016**
(21) Application number: 05104823.9
(22) Date of filing: 02.06.2005
(51) Int. Cl.: H01L 51/40, H01L 51/56

(54) **Substrate for inkjet printing**
Substrat für den Tintenstrahldruck
Substrat pour l'impression par jet d'encre

(43) Date of publication of application: 06.12.2006
(73) Proprietor: Samsung SDI Germany GmbH, 12459 Berlin (DE); Samsung Display Co., Ltd., Gyeonggi-do (KR)
(72) Inventor: Uhlig, Albrecht, Dr., 12524, Berlin (DE); Nolte, Kerstin, Dr., 10789, Berlin (DE); Schrader, Thomas, 12557, Berlin (DE)
(74) Representative: Gulde & Partner

(56) References cited:
- EP-A1- 1 729 358
- WO-A-03/065474
- WO-A-2005/036509
- DE-A1- 10 311 097
- US-A1- 2003 129 321
- US-A1- 2004 195 551
- US-A1- 2005 058 840

## Description

### FIELD OF THE INVENTION

This invention relates to a substrate for ink jet printing and a method for manufacturing the same, more particularly the present invention relates to a substrate to be used for ink jet printing to structure materials onto the substrate surface.

The present invention is not limited to a special class of materials or a special type of device. The materials can be of different nature like light emitting polymers, colour filter materials, biological fluids or metals. The device can be a polymer OLED based displays, colour filters, DNA sensors or others.

All these applications require the exact deposition of the (active) material on a pre-defined active area. Ink jet printing is known as one of possible technologies to serve this purpose. For ink jet printing the active material is dissolved in a supporting solvent to form an ink. This ink is jetted in small portions as a droplet towards the substrate by e.g. piezo or bubble jet printing. The accurate positioning of the droplet onto the active area is realised by mechanical alignment of the ink head in relation to the substrate. After drying of the supporting solvent the (active) ink jetted material forms a film on top of the active area.

One of main failure modes of this technology is the overflow of (at least a part of) the droplet into adjacent active areas. In case of pLED (polymer light emitting diode) devices this leads to unwanted colour mixing.

### BACKGROUND OF THE INVENTION

The inkjet printing process is one of the most important structuring processes for the manufacture of full-colour displays on the basis of light-emitting polymers (LEP's)

US 2002/0004126 A1 discloses a process in which small drops of a solution of the corresponding active material (hole transporting or light emitting materials) are deposited onto the active area within a suitable substrate. The dimensions of the active area (the pixel) in a display designed for use in high resolution displays for mobile application is in the range of 30 µm x 180 µm. State-of-the-art commercial available ink jet heads are capable to generate drop diameters of > 30 µm. Thus the drop diameter and the active area, where the drop is supposed to be placed are in a similar range. To avoid overflow of the droplet into the neighbouring pixels the substrate surface is modified to avoid this effect.

There are two fundamental approaches to solve this problem: create a surface with different wetting properties for the ink or create a surface having geometric barriers to mechanically prevent overflow.

The first fundamental solution approach is described in EP 0 989 778 A1**.** By means of a suitable selection of the materials which form the substrate surface, a contrast of the surface energy is created. The print-applied ink can only flow in the areas with high surface energy, whereas areas with a low surface energy act as a barrier. In order to obtain a homogenous coating thickness of the film, it is furthermore advantageous to set high surface energy beyond the boundary of the pixel surface of the organic light-emitting diode (OLED). The film which is then formed is homogenous up to the boundary zone and the coating thickness then noticeably declines outside of the active zone in the vicinity of the barrier.

The required contrast of the surface energies can be achieved in different ways and with different methods.

EP 0 989 778 A1 describes a two-coating structure of the surface. By means of a suitable surface treatment in the plasma, the upper coating can be provided with low surface energy while the lower coating, because of its chemical nature, receives high surface energy with the same treatment. The lower coating is typically manufactured from inorganic materials such as silicon oxide or silicon nitride. The nature of the plasma gas is specified in a way, that a surface fluorination of the organic layer is ensured. The quantity of the fluorine containing part of the gas is > 60% of the total gas mixture.

The inorganic coating acts here as a boundary zone with high surface energy and facilitates the deposition of homogenous polymer films by means of the inkjet printing process.
However, the deposition and structuring of this coating requires processes which are typically used in the semi-conductor industry. For this coating separation-, sputter- and gas phase processes such as PECVD (Plasma Enhanced Chemical Vapour Deposition) are appropriate. These processes are cost-intensive and subsequently reduce the cost advantage gained by the use of OLED technology. Moreover, the second coating contains the formation of a surface topography, meaning, the areas with low surface energy (here called "separators") set apart with finite height from the substrate surface. As a result of this height profile, the separated polymer film can form an undesirable thickness profile.

JP 09203803 AA describes the chemical treatment of the substrate surface that had been treated with a photo-resist beforehand. Following this, the photo-resist is exposed by means of a mask and developed. In the structure which has occurred in this way, the areas with photo-resist have low surface energy while areas without photo-resist have high surface energy. The flanks of the photo-resist structure indicate mean surface energy and, because of this, can avoid an abrupt transition of the surface energies up to a certain degree. However, they do not represent a boundary zone with a freely selectable surface energy and geometry. This is a disadvantage insofar as the spatial dissolution capacity of the inkjet printing process declines through areas with mean surface energy.

JP09230129 AA describes a two-stage treatment of the surface. First, the entire surface is provided with low surface energy. By means of the subsequent treatment of selected parts of the surface with short-wave (UV) light, the surface energy in these areas is increased again. However, the obtainable contrast of the surface energy is limited and the required UV exposure time to achieve areas of high surface is not compatible with a mass production.

DE 102 36 404 A1 (Samsung SDI) describes the surface fluorination of a photo resist using CF₄ containing plasma process combined with a lift off process for patterning. However this process requires CVD as a vacuum based technology adding considerable process costs and time. Furthermore the adjusted surface energy by surface modification is not stable over time. This is because the photo resist layer will reorganise his surface by diffusion of the fluorinated parts into the bulk to maintain equilibrium. Another disadvantage is that the fluorinated parts do not adhere chemically to the photo resist bulk and will be washed away after exposure to acid containing solutions like PDOT:PSS. This material is commonly used for polymer OLED manufacturing.

DE 103 43 351.**A1** (Samsung SDI) describes the deposition of a hydrophobic layer like Teflon to generate a repulsive function against the ink. This Teflon is deposited by Chemical vapour deposition and patterned by Lift off technologies, laser ablation or by using a shadow mask. However this technology requires CVD or thermal evaporation deposition techniques. Both are vacuum based technologies, and will add considerable process costs and time.

US 6,656,611 B2 (Osram OS) describes the use of a polysiloxane based photo resist as insulating areas to define active areas of a display. The polysiloxane is preferably structured as a "overhanging structure" to separate the cathode in order to generate a passive matrix display. However the polysiloxane layer has a considerable film thickness and will influence the cathode sheet resistance negatively by metal film separation at the edges of the polysiloxane layer.

EP 1 008 873 (DAINIPPON PRINTING CO LTD) describes a process of colour filter production for LCD displays by ink jet printing. Here the surface energy of a photoactive material can be changed by irradiation. This effect is used to provide shading areas and areas which are inkphilic and where the ink for the colour filters is applied by ink jet printing. As this photoactive material cannot be structured by itself but changes only its surface energy it cannot be used as pixel defining layer for polymer OLED production directly.

A second strategy to prevent overflow is the use of geometrical structures, that acts as a spatial barrier.

US 6,388,377 B1 describes the formation of photo resist strips, that are positioned between adjacent active areas. This strips having a height of > 2 µm acts as a physical barrier to prevent overflow of the ink.

The fabrication of photo-resist structures is described in the EP 0 996 314 A1**.** By means of the boundary limitation of the various rows or columns of a full-colour display screen by means of, e.g., photo-resist, it is ensured that HTL-ink as well as polymer ink can be printed into the pre-structured channels. In this way, red, green and blue emitting polymers can be printed in a line-shaped manner next to each other without polymer flowing into the neighbouring channels and causing a mixing of colours in the process. These limiting photo-resist structures ("bank") therefore form the channels, meaning, they form line structures on the substrate that is then built up to the full-colour display screen and have a certain height. It is therefore ensured that no ink can flow over this photo-resist barrier and into the neighbouring lines. The height of the banks is larger than the film thickness to be deposited by ink jet printing. Furthermore the height is larger than the 1/2 times the quotient of size of the active area(pixel) and the drop diameter. In the same document the upper surface of this banks can have a sub structure as an additional feature. This semicircle or triangular or rectangular sub-structure functions as a reservoir for ink that overflows. By this a second barrier to avoid overflow into the adjacent active areas is provided additionally to the bank structure.

DE 103 11 097 A1 (Samsung SDI) describes the use of additional ink stoppers. As these channels are open at the upper and lower rims, meaning that the photo-resist structures as used at present provide only lateral limitation for the channels, the HTL- and the polymer ink can easily run out from the channels in the upward and downward directions. Therefore, the ink volume in the channels at the upper and lower rim is less than in the zones in the middle of the channels. The negative effect here is that the dried HTL- and polymer film forms layer thickness non homogeneities at the upper and lower rim which are also visible in the electroluminescence emission. This occurs because the layer thickness of the HTL-and polymer film gradually becomes thinner, something which is directly related to the running out of the HTL- and polymer inks from the channels. The use of ink stoppers prevents this effect by avoiding flow out of the ink.

US 2003/0042849 A1 (SEL) describes another unique approach to define the drop landing / film formation for ink jet printed devices. Here a mechanical metal mask is positioned and fixed onto the substrate in the way that the organic emitter can be applied using spin coating technique. However, the use of metal shadow masks has a limit in terms of substrate size. At larger substrates different thermal extension coefficients and a not perfectly planar surface of the mask or the substrate will cause misalignment.

WO 2005/036509 A2 discloses an exemplary substrate for ink jet printing of the prior art.

However, all printing techniques known in the state of the art require cost-intensive process steps or comprise low spatial resolution.

### OBJECTS OF THE INVENTION

Therefore one object of the invention is to provide a substrate for ink jet printing and a method for manufacturing the same which allow the deposition of liquid materials by ink jet printing with a high spatial resolution while avoiding overflow of the ink into adjacent areas. Another object of the invention is to provide a substrate which requires simple low cost manufacturing technology and which is not limited to a certain substrate size.

### SUMMARY OF THE INVENTION

According to the invention there is provided a substrate for ink jet printing as defined in claim 1. According to a preferred embodiment of the invention said first layer and said second layer are formed of an organic material which requires low cost manufacturing processes. In a very preferred embodiment of the invention said first layer and said second layer are photo resist layers. In a preferred embodiment the first surface energy of said first layer is higher than 40 mJ/m² and the second surface energy of said second layer is lower than 30 mJ/m².

The main idea of the invention is to surround the active area (for example the pixel area to be coated with the ink) by two different types of layers (coatings) neighbouring each other. These layers (coatings) have two functions: first to define the active (pixel) area and second to define the area where the active film will be positioned after ink jet printing and drying of the ink. When an ink repelling substance is disposed in order to define the border of an active area or to avoid overflow of the ink into adjacent areas the ink repelling substance causes the ink to be inhomogeneous (in respect of its thickness) after drying because the ink is pushed away from the border area due to the presence of the ink repelling substance.

The invention is characterised in that areas of different surface energy (i.e. first layer and second layer) are positioned neighboring each other (side by side) but not on top of each other.

In the present invention the function of the two neighbouring layers (coatings) is to draw the ink over the boundary of the underlying active area and to avoid the film spreading into the next active area. Therefore a homogeneous film can be obtained after ink jet printing.

The first layer (coating) has a surface tension that assists the film forming of the ink onto this layer. Therefore the surface energy of the first layer has to be larger than the surface energy of the ink. The second layer has a surface tension that repels the film preventing film coating on the second layer. Therefore the surface energy of the second layer has to be lower than the surface energy of the ink. Therefore the two layers differ in their surface tension, one (first layer) is larger than the surface tension of the ink and one (second layer) is lower than the surface tension of the ink. Preferably the lateral dimension of the first layer amounts between 5% and 25% of the lateral dimension of the active area, in a very preferred embodiment the lateral dimension of the first layer amounts between 10% and 20% of the lateral dimension of the active area and in another very preferred embodiment the lateral dimension of the first layer amounts to 15% of the lateral dimension of the active area.

According to the invention two different types of standard photo resists can be used to generate this effect. Thus, the technology is easy and straightforward.

After the deposition of a drop of ink onto the active area of a substrate according to the invention the liquid ink will coat the active area as well as the first layer (coating) because of the explained relations of the surface energy. The spreading of the liquid ink will be stopped at the second layer (coating) because of the lower surface energy of this layer (coating).

In the subsequent step of film drying a homogeneous film can be formed which covers the active area and the first layer but does not cover the second layer. Thus an overflow and subsequent film forming in neighbouring active areas is prevented.
As already mentioned the film thickness homogeneity over the active area is high, because the border area (edges) of the active area is covered completely with the active film (dried ink). In case of absence of the first layer the active film would show non uniform thickness profile, especially the height of the dried ink in the border area (edge) will be lower because the ink is repelled by the second layer.

Preferably a layer of a transparent electrode consisting of a transparent oxide (for example Indium Tin Oxide and the like) is disposed on the ground substrate in the active areas. In this case the active film will cover the layer of the transparent electrode after drying. Preferably the first la,yer is disposed on the layer of the transparent electrode and the second layer partially covers the layer of the transparent electrode.

Preferably the first layer and the second layer comprise a thickness between 100 nm and 20 µm. Preferably the active areas are arranged in a matrix with rows and columns. Preferably the thickness of the first layer is lower than the thickness of the second layer. In a very preferred embodiment the thickness of the second layer amounts to the sum of the thickness of the first layer and the thickness of an underlying layer of transparent electrode.

Preferably each active area is separated from all adjacent active areas by the first and second .layer which represent the non-active area. In an, alternative preferred embodiment of the invention only the active areas of different lines or different columns of the matrix are separated from each other by the second (repellent) layer.

Further, there is provided a method for producing a substrate for ink jet printing as defined in claim 10.

Preferably the first organic structure and second organic structure are applied with a thickness between 100 nm and 20 µm. Preferably the first organic structure and second organic structure are applied by application of a continuous layer of an organic material followed by tempering of the continuous layer, exposure of the continuous layer and a structuring process whereby the tempering for the first organic structure is carried out at a temperature between 100°C and 140 °C for a time between 1 minute and 5 minutes, the tempering for the second organic structure is carried out at a temperature between 140°C and 240°C for a time between 10 minute and 40 minutes, the exposure for the first organic structure is carried out with an energy density between 60-120 mJ/cm² and the exposure for the second organic structure is carried out with an energy density between 300-700 mJ/cm²_{.}

In summary the advantages of the present invention are:
- generation of a surface for ink jet printing technologies with high contrast in surface energy by choice of material intrinsically having a pre-defined surface energy,
- simple deposition technology allowing a low cost process,
- no additional adhesion problems or mechanical stress occur because the two different materials, i.e. the first layer and the second layer (low and high surface energy) are not staged on top of each other,
- low differences in height avoiding cathode film separation,
- low overall film thickness reducing the quantity of outgassing species which are harmful to OLED lifetime,
- prevention of a vacuum requiring process technology to adjust the surface energy of the substrate,
- prevention of any further surface treatment for purpose of generating surface energy contrasts,
- robustness of the substrate surface against thermal treatment,
- robustness of the substrate surface against further technology steps like UV/ ozone or oxygen plasma treatment, and
- prevention of use of inorganic material avoiding complicated structuring technologies.

### BRIEF DESCRIPTION OF THE DRAWINGS

The present invention will now be described by way of example with reference to the accompanying drawings, in which:
- Fig. 1: shows a top view of a first embodiment of a substrate according to the present invention,
- Fig. 2: shows a top view of a second embodiment of a substrate according to the present invention,
- Fig. 3: shows a sectional view of a substrate according to the present invention before ink jet printing,
- Fig. 4: shows a sectional view of a substrate according to the present invention after printing and drying of the ink, and
- Fig. 5: shows a sectional view of a conventional substrate (comparative example) after printing and drying of the ink.

### DETAILED DESCRIPTION OF PREFERRED EMBODIMENTS

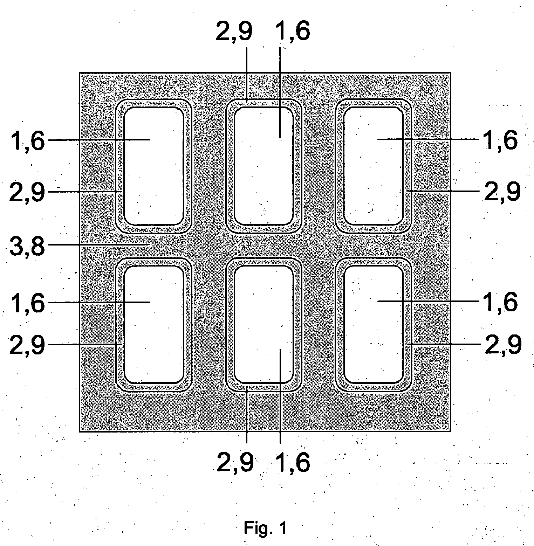

Fig. 1 shows a top view of a first embodiment of a substrate according to the present invention. The substrate comprises a plurality of active areas 6 (in a matrix arrangement) which are laid underneath with an Indium Tin Oxide layer 1. The first organic layer 2 (photo resist) having a high surface energy of more than 40mJ/m² is structured in that way that it surrounds the active area but do not build a continuous film. The second organic layer 3 (photo resist) having a low surface energy lower than 30 mJ/m² is structured in that way that it covers the remaining area of the substrate, i.e. it forms the repellent area 8 in that way that each active area is separated from the neighbouring active areas by this repellent area.

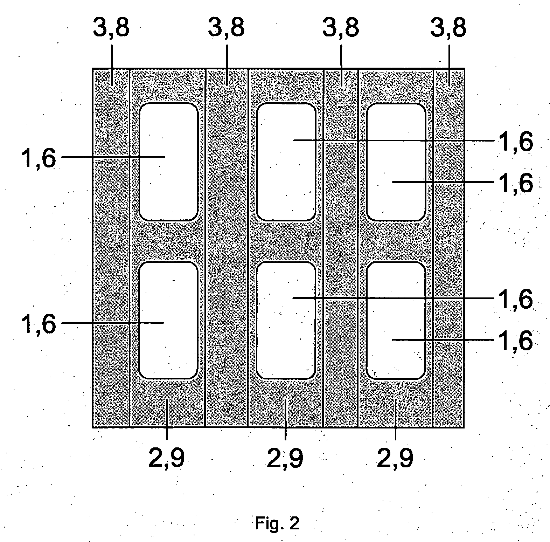

Fig. 2 shows a top view of a second embodiment of a substrate according to the present invention. In this embodiment the active areas 6 of one column are surrounded by the organic layer 2 (photo resist) having a high surface energy in that way that this organic layer 2 forms a continuous film throughout the column. The different columns of actice areas 6 are separated from each other by the second organic layer 3 (photo resist) having a low surface energy. This application is useful if a plurality of vertical lines shall be printed on the substrate by ink jet printing, the plurality of vertical lines having different colours. In this case it is not necessary to prevent overflow of ink into adjacent areas of the same column because the active areas of the same column shall all be filled with ink of the same colour. In order to prevent overflow of ink into adjacent areas of different columns (different colours) the second organic layers 3 separates different columns from each other.

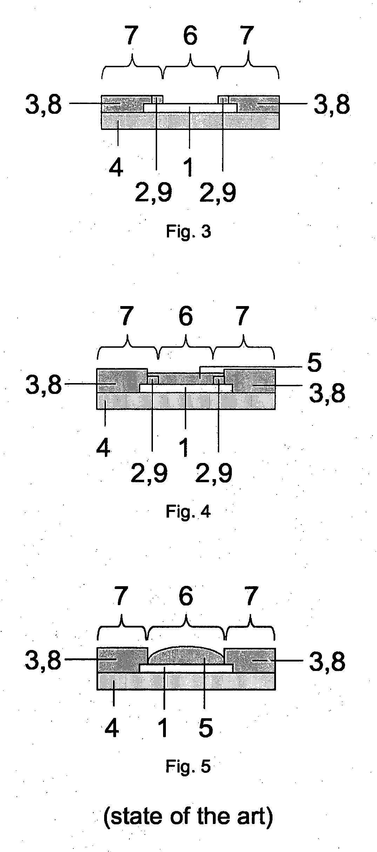

Fig. 3 shows a sectional view of a substrate according to the present invention before ink jet printing. Again it can be seen that the first organic layer 2 is surrounding the active areas 6 in that way that it forms the border area 9 and the second organic layer 3 is structured in such a way that it forms the repellent areas 8 wherein the first organic layer 2 and the second organic layer 3 are disposed side by side, i.e. the first organic layer 2 and the second organic layer 3 are in lateral contact with each other. In this embodiment the top surfaces of the first organic layer 2 and the second organic layer 3 comprise the same height over the ground substrate 4 which is of planar shape and which can be made of glass, SiOₓN_{y}, plastic or the like. Therefore the thicknesses of layers 1 and 2 equal to the thickness of layer 3.

In an alternative embodiment of the invention (see Fig. 4) the second organic layer 3 comprises a higher vertical extension over the ground substrate 4 than the first organic layer 2. Fig. 4 shows a sectional view of a substrate according to the present invention after printing and drying of the ink. Due to the presence of the first organic layer 2 disposed in the border area 9 of the active area 6, the first organic layer 2 having a higher surface energy than second organic layer 3, the ink spreads not only the active area 6 but also the border area 9 (the first organic layer 2) while it is repelled by the second organic layer 3 which results in a high film thickness homogeneity (of the film 5 which is the result of the dried ink) over the active area 6. In the border area 9 the film 5 does not belong to the active area 6 because it is separated from the anode (indium tin oxide 1) by the first organic layer 2 and therefore the part of the film 5 which is located in the border.area 9 will not emit light.

In comparison to that Fig. 5 shows a sectional view of a conventional substrate after printing and drying of the ink (comparative example) in which a low film thickness homogeneity of the film 5 over the active area 6 is obtained due to the repelling effect of the second organic layer 3 which directly surrounds the active area 6.

The substrate according to Fig. 4 can be manufactured as follows:
An Indium Tin Oxide (100nm) coated soda lime glass is used as ground substrate 4. The Indium Tin Oxide is structured to form a grid like structure as required for passive matrix devices by standard technologies. The substrate is wet cleaned by high pressure DI (de-ionized) water, megasonic DI water and IPA puddle process (A puddle process means a dispensation of a developer or other media onto the substrate until the complete substrate is wetted. This can be performed under slow rotation. For a defined time this puddle remains on the substrate without rotation). In a next step the substrate is UV ozone treated for 15 min (18mW/cm²).
   In a next step a photo resist (SL 1104-4 of Toray Industries Inc.) is applied by spin coating to generate a 1 µm thick continuous film. This resin is a positive tone resin that means the exposed areas can be solved by the developer while the non-exposed areas remain on the substrate. The surface energy of this photo resist amounts 40mJ/m² and rises up to 70mJ/m² after UV/ozone treatment.

After soft bake (120°C for 3.5 min) and exposure (90 mJ/cm²) the substrate is treated with a mixture of developer (AZ MIF 726 Clariant Inc.) and water in the ratio of 1:3 applying a puddle process to develop the desired photo resist structure 2. This developing step is followed by a hard baking step (160°C for 15 min followed by 15 min at 230 °C).

In a next step a wet cleaning by megasonic DI water and IPA puddle process is applied to clean the surface followed by a UV/ozone treatment for 15 min again.

In a next step photo resist (WL 5150 of Dow Corning) is applied by spin coating to generate a 1 µm thick film. This resin is a negative tone resin that means the areas that are exposed will remain on the substrate while the non-exposed areas are solved by the developer. The surface energy of this photo resist amounts 27mJ/m2_{.}

After soft bake (110°C for 2 min) and exposure (500 mJ/cm²) and a second baking (2 min at 260°C) the substrate is treated with mesitylene (Roth) as developer by puddle process to develop the desired photo resist structure 3. This developing step is followed by a hard baking step (230°C for 30 min).

While this invention has been described in conjunction with specific embodiments thereof, it is evident that many alternatives, modifications and variations will be apparent to those skilled in the art. Accordingly, the preferred embodiments of the invention as set forth herein are intended to be illustrative, not limiting. Various changes may be made without departing from the scope of the invention as defined in the following claims.

### List of Reference Signs

- 1: Indium Tin Oxide
- 2: First Organic Layer
- 3: Second Organic Layer
- 4: Ground Substrate
- 5: Film after drying of Ink Droplet
- 6: Active Area
- 7: Non-active Area
- 8: Repellent Area
- 9: Border Area of Active Area

## Claims

1. Substrate for ink jet printing comprising:
a ground substrate (4),
a plurality of active areas (1, 6), on which ink shall be applied, and at least one non-active area (3, 7), on which no ink shall be applied, both arranged on the substrate (4),
a first layer (2) on the ground substrate (4) having a first surface energy and surrounding the border of each active area (1, 6), and
a second layer (3) on the ground substrate (4) having a second surface energy,
whereby the first surface energy of said first layer (2) is higher than the second surface energy of said second layer (3),
**characterized in that**
said first layer (2) and said second layer (3) are disposed neighbouring each other side by side but not on top of each other in respect to the surface of the ground substrate (4)

2. Substrate according to Claim 1, **wherein**
a layer (1) of a transparent electrode is disposed on the ground substrate (4) in the active areas (1, 6).

3. Substrate according to Claim 2, **wherein**
the first layer (2) is disposed on the layer (1) of the transparent electrode.

4. Substrate according to one of the claims 2 or 3, **wherein**
the second layer (3) partially covers the layer (1) of the transparent electrode.

5. Substrate according to one of the preceding claims, **wherein**
the first layer (2) and the second layer (3) are formed of an organic material.

6. Substrate according to one of the preceding claims, **wherein**
the first layer (1) and the second layer (3) are formed of a photo resist.

7. Substrate according to one of the preceding claims, **wherein**
each active area (1, 6) is separated from all adjacent active areas (1, 6) by the second layer (3).

8. Substrate according to one of the preceding claims, **wherein**
the first layer (2) and the second layer (3) comprise a thickness between 100 nm and 20 µm.

9. Substrate according to one of the claims 1-6 and 8, **wherein**
the active areas (1, 6) are arranged in a matrix and only the active areas (1, 6) of different rows or different columns of the matrix are separated from each other by the second layer (3).

10. Method for producing a substrate for ink jet printing comprising the steps of:
- providing a ground substrate (4);
- defining a plurality of active areas (1,6) on which ink shall be applied, and at least one non-active area (3, 7), on which no ink shall be applied, on the substrate (4),
- application of a first layer (2) on the ground substrate (4) surrounding the border of the active areas (6),
- application of a second layer (3) on the ground substrate (4)covering the remaining area of the substrate (4), whereby the second layer (3) comprises a lower surface energy than the first layer (2), and wherein the first layer (2) and the second layer (3) are formed of an organic material,
**characterized in that**
the second layer (3) and first layer (2) are disposed neighbouring each other side by side but not on top of each other.

11. Method according to claim 10, **wherein**
first layer (2) and second layer (3) are applied with a thickness between 100 nm and 20 µm.

12. Method according to claims 10 or 11, **wherein**
first layer (2) and second layer (3) are applied by application of a continuous layer of an organic material followed by tempering of the continuous layer, exposure of the continuous layer and a structuring process.

13. Method according to claim 12, **wherein**
the tempering for the first layer (2) is carried out at a temperature between 100°C and 140°C for a time between 1 minutes and 5 minutes, the tempering for the second layer (3) is carried out at a temperature between 140°C and 240°C for a time between 10 minute and 40 minutes, the exposure for the first layer (2) is carried out with an energy density between 60-120 mJ/cm² and the exposure for the second layer (3) is carried out with an energy density between 300-700 mJ/cm².

## Patentansprüche

1. Substrat für den Tintenstrahldruck, umfassend:
ein Grundsubstrat (4),
eine Mehrzahl von aktiven Bereichen (1, 6), auf die Tinte aufgebracht werden soll, und mindestens einen inaktiven Bereich (3, 7), auf den keine Tinte aufgebracht werden soll, beide angeordnet auf dem Substrat (4);
eine erste Schicht (2) auf dem Grundsubstrat (4), die eine erste Oberflächenenergie aufweist und die Umrandung jedes aktiven Bereichs (1, 6) bildet, und
eine zweite Schicht (3) auf dem Grundsubstrat (4), die eine zweite Oberflächenenergie aufweist,
wobei die erste Oberflächenenergie der ersten Schicht (2) höher als die zweite Oberflächenenergie der zweiten Schicht (3) ist,
**dadurch gekennzeichnet, dass**
die erste Schicht (2) und die zweite Schicht (3) einander benachbart nebeneinander, aber nicht übereinander bezüglich der Oberfläche des Grundsubstrats (4) angeordnet sind.

2. Substrat nach Anspruch 1, **wobei**
eine Schicht (1) einer transparenten Elektrode auf dem Grundsubstrat (4) in den aktiven Bereichen (1, 6) angeordnet ist.

3. Substrat nach Anspruch 2, **wobei**
die erste Schicht (2) auf der Schicht (1) der transparenten Elektrode angeordnet ist.

4. Substrat nach einem der Ansprüche 2 oder 3, **wobei**
die zweite Schicht (3) die Schicht (1) der transparenten Elektrode teilweise bedeckt.

5. Substrat nach einem der vorangehenden Ansprüche, **wobei**
die erste Schicht (2) und die zweite Schicht (3) aus einem organischen Material gebildet sind.

6. Substrat nach einem der vorangehenden Ansprüche, **wobei**
die erste Schicht (1) und die zweite Schicht (3) aus einem Photoresist gebildet sind.

7. Substrat nach einem der vorangehenden Ansprüche, **wobei**
jeder aktive Bereich (1, 6) von allen benachbarten aktiven Bereichen (1, 6) durch die zweite Schicht (3) getrennt ist.

8. Substrat nach einem der vorangehenden Ansprüche, **wobei**
die erste Schicht (2) und die zweite Schicht (3) eine Dicke zwischen 100 nm und 20 µm umfassen.

9. Substrat nach einem der Ansprüche 1 - 6 und 8, **wobei**
die aktiven Bereiche (1, 6) in einer Matrix angeordnet sind und nur die aktiven Bereiche (1, 6) anderer Reihen oder anderer Spalten der Matrix durch die zweite Schicht (3) voneinander getrennt sind.

10. Verfahren zur Herstellung eines Substrats für den Tintenstrahldruck, umfassend die folgenden Schritte:
- Bereitstellen eines Grundsubstrats (4);
- Festlegen einer Mehrzahl von aktiven Bereichen (1, 6), auf die Tinte aufgebracht werden soll, und mindestens eines inaktiven Bereichs (3, 7), auf den keine Tinte aufgebracht werden soll, auf dem Substrat (4),
- Aufbringen einer ersten Schicht (2) auf das Grundsubstrat (4), die die Umrandung der aktiven Bereiche (6) bildet,
- Aufbringen einer zweiten Schicht (3) auf das Grundsubstrat (4), die die restliche Fläche des Substrats (4) bedeckt, wobei die zweite Schicht (3) eine geringere Oberflächenenergie als die erste Schicht (2) umfasst, und wobei die erste Schicht (2) und die zweite Schicht (3) aus einem organischen Material gebildet werden,
**dadurch gekennzeichnet, dass**
die zweite Schicht (3) und die erste Schicht (2) einander benachbart nebeneinander, aber nicht übereinander angeordnet sind.

11. Verfahren nach Anspruch 10, **wobei**
erste Schicht (2) und zweite Schicht (3) mit einer Dicke zwischen 100 nm und 20 µm aufgebracht werden.

12. Verfahren nach den Ansprüchen 10 oder 11, **wobei**
erste Schicht (2) und zweite Schicht (3) aufgebracht werden durch Aufbringen einer zusammenhängenden Schicht eines organischen Materials, gefolgt von Tempern der zusammenhängenden Schicht, Belichten der zusammenhängenden Schicht und einem Strukturierungsprozess.

13. Verfahren nach Anspruch 12, **wobei**
das Tempern der ersten Schicht (2) bei einer Temperatur zwischen 100 °C und 140 °C über eine Zeitdauer zwischen 1 Minute und 5 Minuten durchgeführt wird, das Tempern der zweiten Schicht (3) bei einer Temperatur zwischen 140 °C und 240 °C über eine Zeitdauer zwischen 10 Minuten und 40 Minuten durchgeführt wird, das Belichten bei der ersten Schicht (2) mit einer Energiedichte zwischen 60 und 120 mJ/cm² durchgeführt wird und das Belichten bei der zweiten Schicht (3) mit einer Energiedichte zwischen 300 und 700 mJ/cm² durchgeführt wird.

## Revendications

1. Substrat pour impression à jet d'encre comprenant :
un substrat de base (4),
une pluralité de zones actives (1, 6), sur lesquelles l'encre doit être appliquée, et au moins une zone inactive (3, 7), sur laquelle aucune encre ne doit être appliquée, agencées toutes deux sur le substrat (4),
une première couche (2) sur le substrat de base (4) ayant une première énergie de surface et entourant la limite de chaque zone active (1, 6), et
une deuxième couche (3) sur le substrat de base (4) ayant une deuxième énergie de surface,
moyennant quoi la première énergie de surface de ladite première couche (2) est supérieure à la deuxième énergie de surface de ladite deuxième couche (3),
**caractérisé en ce que** :
ladite première couche (2) et ladite deuxième couche (3) sont disposées au voisinage l'une de l'autre côte à côte mais pas l'une sur l'autre par rapport à la surface du substrat de base (4).

2. Substrat selon la revendication 1, dans lequel :
une couche (1) d'une électrode transparente est disposée sur le substrat de base (4) dans les zones actives (1, 6).

3. Substrat selon la revendication 2, dans lequel :
la première couche (2) est disposée sur la couche (1) de l'électrode transparente.

4. Substrat selon l'une des revendications 2 ou 3, dans lequel :
la deuxième couche (3) couvre partiellement la couche (1) de l'électrode transparente.

5. Substrat selon l'une des revendications précédentes, dans lequel :
la première couche (2) et la deuxième couche (3) sont formées d'une matière organique.

6. Substrat selon l'une des revendications précédentes, dans lequel :
la première couche (1) et la deuxième couche (3) sont formées d'une résine photosensible.

7. Substrat selon l'une des revendications précédentes, dans lequel :
chaque zone active (1, 6) est séparée de toutes les zones actives adjacentes (1, 6) par la deuxième couche (3).

8. Substrat selon l'une des revendications précédentes, dans lequel la première couche (2) et la deuxième couche (3) consistent en une épaisseur comprise entre 100 nm et 20 µm.

9. Substrat selon l'une des revendications 1 à 6 et 8, dans lequel :
les zones actives (1, 6) sont agencées dans une matrice et seulement les zones actives (1, 6) de différentes rangées ou de différentes colonnes de la matrice sont séparées les unes des autres par la deuxième couche (3).

10. Procédé de production d'un substrat pour impression à jet d'encre comprenant les étapes qui consistent :
- à fournir un substrat de base (4) ;
- à définir une pluralité de zones actives (1, 6) sur lesquelles l'encre doit être appliquée, et au moins une zone inactive (3, 7) sur laquelle aucune encre ne doit être appliquée, sur le substrat (4),
- à appliquer une première couche (2) sur le substrat de base (4) entourant la limite des zones actives (6),
- à appliquer une deuxième couche (3) sur le substrat de base (4) couvrant la zone restante du substrat (4), moyennant quoi la deuxième couche (3) comprend une énergie de surface inférieure à celle de la première couche (2), et où la première couche (2) et la deuxième couche (3) sont formées d'une matière organique,
**caractérisé en ce que** :
la deuxième couche (3) et la première couche (2) sont disposées au voisinage l'une de l'autre côte à côte mais pas l'une sur l'autre.

11. Procédé selon la revendication 10, dans lequel :
la première couche (2) et la deuxième couche (3) sont appliquées avec une épaisseur comprise entre 100 nm et 20 µm.

12. Procédé selon les revendications 10 ou 11, dans lequel :
la première couche (2) et la deuxième couche (3) sont appliquées par application d'une couche continue d'une matière organique suivie du revenu de la couche continue, de l'exposition de la couche continue et d'un processus de structuration.

13. Procédé selon la revendication 12, dans lequel :
le revenu de la première couche (2) est effectué à une température comprise entre 100°C et 140°C pendant une durée comprise entre 1 minute et 5 minutes, le revenu de la deuxième couche (3) est effectué à une température comprise entre 140°C et 240°C pendant une durée comprise entre 10 minutes et 40 minutes, l'exposition de la première couche (2) est effectuée avec une densité d'énergie comprise entre 60 et 120 mJ/cm² et l'exposition de la deuxième couche (3) est effectuée avec une densité d'énergie comprise entre 300 et 700 mJ/cm².
